# EUROPÄISCHE PATENTSCHRIFT

(11) **EP 2 482 089 B1**
(45) Veröffentlichungstag und Bekanntmachung des Hinweises auf die Patenterteilung: **13.06.2018**
(21) Anmeldenummer: 12002235.5
(22) Anmeldetag: 24.02.2010
(51) Int. Cl.: G01R 31/02, G01R 31/08, G01R 35/00, G01R 31/12

(54) **Verfahren und System zur Ortung eines Fehlers auf einem Kabel**
Method and system for locating a defect in a cable
Procédé et système de localisation d'une erreur sur un câble

(43) Veröffentlichungstag der Anmeldung: 01.08.2012
(62) Teilanmeldung aus: 10001913.2
(73) Patentinhaber: Omicron electronics GmbH, 6833 Klaus (AT)
(72) Erfinder: Klapper, Ulrich, 6830 Rankweil (AT); Emanuel, Harald, 10553 Berlin (DE); Steineke, Caspar, 10625 Berlin (DE)
(74) Vertreter: Banzer, Hans-Jörg

(56) Entgegenhaltungen:
- EP-A1- 2 071 342
- WO-A1-2005/121821
- DE-A1- 3 912 654
- US-A- 3 991 364
- US-A- 5 323 117
- US-A- 5 729 145
- US-A- 6 161 077

## Beschreibung

Die vorliegende Erfindung betrifft ein Verfahren zur Ortung einer Fehlstelle auf einem Kabel durch Auswertung von Teilentladungen sowie entsprechende Systeme.

Zur Messung von Teilentladungen (so genannten Partial Discharges, PD) gemäß der Norm IEC 60270 ist es vorgeschrieben und notwendig, vor der eigentlichen Messung die Messeinrichtung zu kalibrieren. Üblicherweise wird zur Kalibrierung eine Kalibriereinrichtung zwischen dem Prüfobjekt und Erde angeschlossen, welche simulierte Teilentladungspulse bekannter Ladung in das Prüfobjekt einspeist. Die Teilentladungsmesseinrichtung wird auf ein Frequenzband mit kleinen Umgebungsstörpegeln eingestellt und wird für dieses Frequenzband derart justiert, dass sie genau die von der Kalibriereinrichtung eingespeiste Ladung anzeigt. Bei einer Veränderung des Frequenzbandes in Breite oder Lage ist üblicherweise eine Neukalibrierung erforderlich. Die Impulsform für die Teilentladungskalibrierung ist in der Norm IEC 60270 vorgeschrieben und kommt einem Dirac-Impuls nahe, d.h. es handelt sich um kurze Pulse hoher Amplitude mit einem weiten Frequenzspektrum. Die Pulse werden in kurzen Abständen wiederholt, um eine regelmäßige Anzeige bei der Messeinrichtung zu erhalten. Daher kann das Teilentladungskalibriersignal als ein periodisches Signal aufgefasst werden und ein entsprechender Crest-Faktor, welcher das Verhältnis von Spitzenwerten zu Effektivwerten angibt, berechnet werden. Bei den zuvor beschriebenen Kalibriersignalen mit Impulsform und hoher Amplitude ergeben sich sehr hohe Werte für den Crest-Faktor. Das bedeutet, dass die zu kalibrierende Teilentladungsmesseinrichtung einen Messbereich mit großer Dynamik und hoher Genauigkeit aufweisen muss.

Die Auskopplung des Messsignals erfolgt üblicherweise mit Hilfe von Koppelkondensatoren, die für die Messung angebracht werden, oder mit Hilfe von Kapazitäten, die systeminhärent vorhanden sind, wie z.B. kapazitive Durchführungen von Transformatoren oder Leistungsschaltern oder kapazitive Beläge an Energiekabeln, die zwischen Schirm und Seele des Kabels vorhanden sind. Die zur Kalibrierung angeschlossene Kalibriereinrichtung wird nach der Kalibrierung üblicherweise entfernt, da sie der Prüfspannung nicht standhalten kann. Danach wird an das Prüfobjekt eine Prüfspannung angelegt und die eigentliche Teilentladungsmessung durchgeführt.

Bei einer Teilentladungsmessung an einem Kabel kann der Abstand von einer Messeinrichtung, die sich in der Regel an einem Kabelende befindet, zu einer Störstelle an einem Fehlerort in dem Kabel üblicherweise indirekt durch eine Bestimmung von Signallaufzeiten von Störimpulsen bestimmt werden. Die Bestimmung des Fehlerortes wird üblicherweise durchgeführt, indem eine Prüfspannung an das Kabel angelegt wird. An dem Fehlerort entstehen dann Teilentladungspulse. Die Pulse haben eine gewisse Laufzeit bis sie bei der Messeinrichtung eintreffen. Dadurch, dass am Kabelende für jeden Puls ein Echo entsteht, kann die Differenz der Laufzeiten zwischen Puls und Echo gemessen werden. Ist der Fehlerort sehr nahe am Ende des Kabels, ist die Laufzeitdifferenz zwischen Puls und Echo klein. Eine große Laufzeitdifferenz zeigt einen Fehler nahe bei der Messstelle an. Um berechnen zu können, wo sich der Fehlerort exakt befindet, muss die Geschwindigkeit mit der sich ein Störimpuls im Kabel fortpflanzt, bekannt sein. Diese kann mittels eines Kalibrierimpulses bestimmt werden, der vorzugsweise bei der Messeinrichtung in das nahe Kabelende eingespeist und am fernen Ende des Kabels reflektiert wird. Die Laufzeit wird berechnet und daraus die Geschwindigkeit der Impulsausbreitung bestimmt. Die Geschwindigkeit hängt von der Temperatur des Kabels und dem betrachteten Frequenzfenster der Messung ab.

In diesem Zusammenhang beschreibt die US 3,991,364 ein Autokorrelationsverfahren zum Erfassen von Isolationsfehlern in einem Kabel. Defekte in einem Kabel werden lokalisiert, indem bewirkt wird, dass der Defekt einen Spannungspuls ausgibt, welcher sich in entgegengesetzte Richtungen ausbreitet. Ein Puls wird an einem Ende reflektiert und erreicht das andere Kabelende später als der andere Puls. Die Verzögerung zeigt den Ort des Defekts an und wird bestimmt durch Ausbilden der Autokorrelationsfunktion von Wechselstromsignalen, welche an dem anderen Kabelende erscheinen. Damit eine Phaseneinstellung der Autokorrelationsfunktion der Verzögerung gleicht, weist die Funktion eine hervortretende Spitze auf. Eine Kalibrierung auf der Grundlage eines Korrelierens einer Anregung mit ihrer Reflexion stellt eine maximale Verzögerung bereit, welche als eine Referenz dient, um Defekte mit dem Autokorrelationsverfahren zu lokalisieren.

Die US 6,161,077 betrifft ein Pulsentladungsortungssystem (PDSL), welches Pulse an einem Leiter erfasst, ohne Triggerfunktionen eines Oszilloskops zu benötigen. Das PDSL-System umfasst ein Pulsentladungsmesssystem (PDM) und ist programmiert, um die von dem PDM-System erfassten Daten in einem Referenzpuffer zu speichern, welcher in seiner Größe der Ausbreitungszeit eines Pulses entlang der Länge des Leiters entspricht. Abtastwerte des erfassten Pulses werden abgetastet, um Spitzen von Pulsen über einem ausgewählten Rauschpegel zu lokalisieren. Diese Pulse werden in einem temporären Arbeitspuffer zusammen mit einer ausgewählten Anzahl von Abtastwerten gespeichert, normalisiert und dann zu dem Referenzpuffer hinzuaddiert. Der Referenzpuffer stellt einen statistischen Mittelwert der Pulsaktivität bereit. Primärpulse und ihre Reflexionen zweiter und höherer Ordnung sowie transiente Störpulse und Funkfrequenzpulse werden an dem Anfang und Ende des Referenzpuffers angezeigt. Reflexionen von ersten reflektierten Pulsen von Fehlerstellen in einem Leiter werden in dem übrigen Abschnitt des Referenzpuffers dargestellt. Fehlerortentfernungen von dem Ende des Kabels können aufgrund der proportionalen Dimensionierung des Referenzpuffers bezogen auf die Länge des Kabels und der Kabelausbreitungszeit bestimmt werden.

Aus der vorhergehenden Beschreibung wird klar, dass das Kalibrieren einer Teilentladungsmesseinrichtung gemäß dem Stand der Technik sehr aufwändig ist, da die Teilentladungsmesseinrichtung bei einem Wechsel des Frequenzbandes oder bei einer sich ändernden Temperatur des Prüfobjekts jeweils neu zu kalibrieren ist, wobei zur Kalibrierung jeweils die Prüfspannung auszuschalten, die Kalibriereinrichtung anzuschließen, und nach der Kalibrierung und vor der eigentlichen Teilentladungsmessung wiederum zu entfernen ist. Darüber hinaus werden bei dem Kalibrierverfahren gemäß dem Stand der Technik hohe Anforderungen bezüglich der Dynamik an Messschaltungen der Teilentladungsmesseinrichtung gestellt. Ähnliches gilt für die derzeitigen Verfahren zur Fehlerortung auf Kabeln.

Aufgabe der vorliegenden Erfindung ist es daher, entsprechende vereinfachte und verbesserte Verfahren bereitzustellen.

Gemäß der vorliegenden Erfindung wird diese Aufgabe durch ein Verfahren zur Ortung von Fehlern auf einem Kabel nach Anspruch 1 und ein Kabelfehlerortungssystem nach Anspruch 14 gelöst. Die abhängigen Ansprüche definieren bevorzugte und vorteilhafte Ausführungsformen der Erfindung.

Gemäß einer Ausführungsform der vorliegenden Erfindung wird ein Verfahren zur Kalibrierung einer Teilentladungsmesseinrichtung bereitgestellt. Bei dem Verfahren wird ein periodisches Kalibriersignal mit einem sich periodisch wiederholenden Signalverlauf von vorbestimmter Periodendauer erzeugt. Das periodische Kalibriersignal wird beispielsweise in ein Prüfobjekt eingekoppelt und ein Messsignal wird von der Teilentladungsmesseinrichtung erfasst. Das Messsignal kann mehrere Messsignalabschnitte mit jeweils der vorbestimmten Periodendauer des Kalibriersignals umfassen. Die vorbestimmte Periodendauer wird zur Mittelung des Messsignals herangezogen. Beispielsweise wird durch eine Mittelung von mehreren Messsignalabschnitten mit jeweils der vorbestimmten Periodendauer ein gemittelter Messsignalabschnitt bestimmt. Auf der Grundlage dieses gemittelten Messsignalabschnitts kann dann die Teilentladungsmesseinrichtung kalibriert werden. Zur Bestimmung des gemittelten Messsignalabschnitts können beispielsweise viele tausend Messsignalabschnitte herangezogen werden, die nacheinander an dem Prüfobjekt erfasst werden, während das periodische Kalibriersignal in das Prüfobjekt eingekoppelt wird. Indem ein periodisches Kalibriersignal mit einem definierten Amplitudenverlauf eingespeist wird, kann dieses Kalibriersignal im Vergleich zu anderen Signalen in dem Prüfobjekt, wie z.B. einem Teilentladungsmesssignal oder einem Störsignal, sehr klein sein, da zur Kalibrierung der Teilentladungsmesseinrichtung der Umstand ausgenutzt werden kann, dass das Kalibriersignal periodisch ist und somit durch eine Mittelung über sehr viele Perioden das Kalibriersignal trotz des kleinen Pegels genau erfasst werden kann.

Gemäß einer Ausführungsform wird bei dem Verfahren eine Prüfspannung an das Prüfobjekt angelegt, während das periodische Kalibriersignal eingekoppelt wird. Dadurch kann bei der Durchführung der Teilentladungsmessung eine große Zeitersparnis erreicht werden und der gesamte Ablauf der Teilentladungsmessung vereinfacht werden. Bei einer Veränderung des Frequenzbandes in der Teilentladungsmesseinrichtung, d.h. z.B. bei einer Verschiebung einer Filterfrequenz der Teilentladungsmesseinrichtung, ist somit kein Aus- und Einschalten der Prüfspannung erforderlich, sondern das Kalibrieren der Teilentladungsmesseinrichtung kann bei eingeschalteter Prüfspannung durchgeführt werden. Darüber hinaus kann die Teilentladungsmesseinrichtung auch kontinuierlich, während die Prüfspannung an das Prüfobjekt angelegt wird, kalibriert werden. Andere mögliche Veränderungen im System, wie z.B. die Temperatur des Prüfobjekts, können dadurch laufend erkannt und wegkalibriert werden. Die Amplitude des periodischen Kalibriersignals wird vorzugsweise kleiner als die erwarteten Amplituden von Teilentladungen in dem Prüfobjekt gewählt. Dadurch beeinflusst das Kalibriersignal das Messergebnis der eigentlichen Teilentladungspulse nicht signifikant. Außerdem lassen sich die kleineren Kalibriersignale einfacher über Koppelkondensatoren auf ein Prüfspannungspotenzial einkoppeln als große Kalibriersignale oder Kalibriersignale mit großer Dynamik.

Gemäß einer weiteren Ausführungsform umfasst der Signalverlauf des Kalibriersignals ein bandbegrenztes weißes Rauschen. Das bandbegrenzte weiße Rauschen kann beispielsweise ein mit Hilfe eines Tiefpassfilters begrenztes weißes Rauschen sein. Weißes Rauschen hat im Vergleich zu wiederholten Impulsen einen wesentlich kleineren Crest-Faktor und weist ferner die Eigenschaft auf, das gesamte Spektrum innerhalb des begrenzten Frequenzbandes abzudecken.

Gemäß einer weiteren Ausführungsform kann das weiße Rauschen mittels einer binären Pseudozufallssequenz erzeugt werden, welche vorzugsweise anschließend tiefpassgefiltert wird.

Gemäß einer weiteren Ausführungsform kann das periodische Kalibriersignal ein Frequenzgemisch aus mehreren diskreten Frequenzen umfassen. Die Frequenzen können beispielsweise derart im Spektrum verteilt sein, dass der gesamte mögliche Bereich der Teilentladungsmessung abgedeckt wird. Durch eine geeignete Wahl der diskreten Frequenzen wird eine Periodizität der gesamten Sequenz erreicht. Die Periodizität der gesamten Frequenz entspricht dem größten gemeinsamen Nenner der diskreten Frequenzen. Bei Verwendung eines 2 kHz- und eines 3 kHz-Signals als die diskreten Frequenzen ergibt sich somit eine Frequenz für das Kalibriersignal von 1 kHz. In einem weiteren Beispiel ergibt sich bei Verwendung eines 2 kHz- und eines 3,1 kHz-Signals als die diskreten Frequenzen ein periodisches Kalibriersignal mit einer Frequenz von 100 Hz. Durch Optimierung der Phasenlage zwischen den diskreten Frequenzen kann eine weitere Verringerung des Crest-Faktors erreicht werden.

Da das eingekoppelte periodische Kalibriersignal gegenüber einem einer Teilentladung in dem Prüfobjekt entsprechenden Teilentladungsmesssignal gering sein kann, kann das Kalibriersignal kontinuierlich während der eigentlichen Teilentladungsmessung angelegt werden, ohne dass die Teilentladungsmessung davon signifikant beeinflusst wird. Das permanente Vorhandensein des Kalibriersignals während der Teilentladungsmessung kann dazu genutzt werden, die Kalibrierung während der Teilentladungsmessung fortlaufend nachzuführen und die Teilentladungsmesseinrichtung so nachzujustieren, dass immer korrekte Ergebnisse angezeigt werden. Dies ist insbesondere dann vorteilhaft, wenn das Frequenzband verschoben oder die Bandbreite verändert wird, aber auch wenn durch Veränderungen in dem Prüfobjekt oder Veränderungen in der Teilentladungsmesseinrichtung eine Nachkalibrierung erforderlich ist.

Gemäß einer weiteren Ausführungsform wird das Messsignal nach beispielsweise einem Bandpassfilter in zumindest zwei Messpfade aufgetrennt. In einem ersten Messpfad wird eine Mittelung über die vorbestimmte Periodendauer durchgeführt und danach eine Teilentladungsmessung durchgeführt. Da echte Teilentladungen und Störsignale nicht genau die vorbestimmte Periodendauer aufweisen, sind sie in diesem Messpfad nicht sichtbar und es wird hier nur das Kalibriersignal gemessen. In einem zweiten Messpfad wird eine herkömmliche Teilentladungsmessung durchgeführt. Wenn das Kalibriersignal so klein gewählt wird, dass es im zweiten Messpfad keine signifikante Änderung hervorruft, kann gleichzeitig eine Teilentladung gemessen werden und das System kalibriert werden.

Gemäß einer weiteren Ausführungsform ist es möglich, bei eingeschalteter Prüfspannungsquelle ein Bandpassfilter zu verändern und ohne Ausschalten der Prüfspannungsquelle eine Neukalibrierung durchzuführen. Dies ist durch die Einkopplung des Kalibriersignals auf Prüfspannungsniveau und die geringe notwendige Dynamik bei Verwendung eines weißen Rauschens möglich. Alternativ kann statt des weißen Rauschens auch ein anderes periodisches Signal verwendet werden.

Gemäß einer weiteren Ausführungsform der vorliegenden Erfindung wird ein Frequenzband des periodischen Kalibriersignals derart gewählt, dass Frequenzen eines Störsignals im Messsignal in dem gewählten Frequenzband kleinere Amplituden als entsprechende Amplituden des periodischen Kalibriersignals aufweisen. Beispielsweise kann ein breitbandiges Kalibriersignal während der Messung angelegt werden und dann ein Bereich im Frequenzband ermittelt werden, bei dem ein Störpegel im Vergleich zum Kalibriersignal klein ist. Das Kalibriersignal kann dabei vorzugsweise einen über die Frequenz konstanten Pegel aufweisen. Der Frequenzgang des Kalibriersignals wird mit dem Frequenzgang des Störpegels verglichen und ein Bereich mit einem großen Abstand zwischen Kalibriersignal und Störpegel ermittelt. Dieser Bereich stellt dann auch einen optimalen Bereich eines Frequenzbandes zur Teilentladungsmessung dar. Das Frequenzband kann beispielsweise mit Hilfe eines Bandpassfilters eingestellt werden.

Bei den beschriebenen Verfahren wird die Kohärenz zwischen dem Kalibriersignal und dem Teil der Teilentladungsmesseinrichtung, der das Kalibriersignal misst, ausgenutzt. Um die Kohärenz sicherzustellen, kann die Teilentladungsmesseinrichtung bezüglich ihrer Phasenlage zu dem Kalibriersignal ausgerichtet werden. Dies kann beispielsweise mit Hilfe eines Phasenregelkreises, eines so genannten Phase Locked Loop (PLL), in der Teilentladungsmesseinrichtung erreicht werden.

Ein weiteres Verfahren der vorliegenden Erfindung ermöglicht, wenn das Prüfobjekt ein elektrisches Kabel mit einer Fehlstelle umfasst, die Bestimmung eines Fehlerorts auf dem Kabel. Dazu wird ein periodisches Kalibriersignal mit einer vorbestimmten Periodendauer in das Kabel eingekoppelt. Das Messsignal wird normalerweise in der Nähe der Einkopplung, vorzugsweise an einem Ende des Kabels, zusammen mit auf dem Kabel entstehenden Teilentladungsimpulsen gemessen und erfasst. Wie zuvor beschrieben, wird ein gemittelter Messsignalabschnitt durch Mittelung von mehreren Messsignalabschnitten mit der vorbestimmten Periodendauer des Messsignals bestimmt. Auf diese Art und Weise können aufgrund der Kohärenz von Kalibriersignal und Mittelung Störsignale beliebig gut unterdrückt werden. Für den gemittelten Messsignalabschnitt wird eine Laufzeit zwischen dem periodischen Kalibriersignal und einem Echo des periodischen Kalibriersignals bestimmt. Mit Hilfe der Laufzeit wird die Entfernung zu einer Position des Kabels, an welcher das Echo erzeugt wurde, bestimmt. Die Position des Kabels, an welcher das Echo erzeugt wird, wird vorzugsweise das Ende des Kabels sein, könnte aber auch eine Störstelle, wie eine Unterbrechung oder ein Kurzschluss des Kabels, sein. Auf diese Art und Weise kann bei bekannter Länge die Laufzeit von Pulsen in einem bestimmten Frequenzband sehr genau bestimmt werden oder bei bekannter Laufzeit bei zumindest einer Frequenz die Länge des Kabels bestimmt werden. Werden auf dem Kabel entstehende Teilentladungspulse auf die gleiche Art und Weise ohne Mittelung in Relation gesetzt, kann der Fehlerort sehr genau bestimmt werden, und eine neue Bestimmung der Laufzeit aufgrund von Temperaturänderungen oder geänderten Messfrequenzbändern ist möglich, ohne die Prüfspannung abschalten zu müssen. Es ist auch möglich, wenn die Laufzeit an einem Kabel bei nur einer Frequenz bekannt ist, bei dieser Frequenz die Kabellänge zu bestimmen, und dann bei anderen Frequenzen, die zur Teilentladungsmessung besser geeignet sind, die Gruppenlaufzeit am Kabel zu bestimmen.

Gemäß einer weiteren Ausführungsform ist das Kalibriersignal ein breitbandiges periodisches Signal mit der vorbestimmten Periodendauer und es wird jeweils für einen bestimmten Frequenzbereich die Gruppenlaufzeit bestimmt. Dazu wird nach beispielsweise einem Bandpassfilter über die vorbestimmte Periodendauer gemittelt und danach die Zeit zwischen dem Kalibriersignal und dem Echo vom Kabelende bestimmt. Die nun bekannte Gruppenlaufzeit wird bei der Messung der Laufzeit der Störimpulse berücksichtigt und die Messung wird daher viel genauer.

Eine weitere Ausführungsform verwendet ein Autokorrelationsverfahren zur Laufzeitmessung.

Gemäß einer weiteren Ausführungsform werden die entstehenden Teilentladungspulse an der Störstelle des Kabels nicht nur zur Bestimmung des Fehlerorts verwendet, sondern auch quantitativ erfasst. Das Kalibriersignal, das verwendet wird, um die Laufzeit des Signals bei bekannter Kabellänge oder die Kabellänge bei bekannter Laufzeit zu bestimmen, kann zusätzlich zur Kalibrierung so wie zuvor beschrieben herangezogen werden.

Gemäß einer weiteren Ausführungsform umfasst das Kalibriersignal ein bandbegrenztes weißes Rauschen.

Gemäß einer weiteren Ausführungsform wird das Kalibiersignal zur Bestimmung der Gruppenlaufzeit, Kabellänge und Kalibrierung des Teilentladungssystems auch bei angelegter Prüfspannung eingekoppelt.

Gemäß einer weiteren Ausführungsform ist das Prüfobjekt ein Energiekabel. Besonders bei diesen Betriebsmitteln ist das Verfahren der Teilentladungsmessung üblich und kann durch die vorgestellte Erfindung besonders stark vereinfacht werden.

Gemäß der vorliegenden Erfindung wird ferner ein Teilentladungsmesssystem bereitgestellt. Das Teilentladungsmesssystem umfasst eine Teilentladungsmesseinrichtung, welche ausgestaltet ist, ein Messsignal an einem Prüfobjekt zu messen, und einen Kalibriersignalgenerator, welcher zum Erzeugen eines Kalibriersignals ausgestaltet ist. Das Kalibriersignal weist eine vorbestimmte Periodendauer aufweist. Die Teilentladungsmesseinrichtung ist ausgestaltet, die vorbestimmte Periodendauer zur Mittelung des Messsignals heranzuziehen.

Gemäß einer Ausführungsform ist das Teilentladungsmesssystem zur Durchführung des zuvor beschriebenen Verfahrens zur Kalibrierung der Teilentladungsmesseinrichtung ausgestaltet und umfasst daher auch die zuvor beschriebenen Vorteile.

Gemäß der vorliegenden Erfindung wird weiterhin ein Kabelfehlerortungssystem zur Ortung von Fehlern auf einem Kabel bereitgestellt. Das Kabelfehlerortungssystem umfasst eine Signalerzeugungsvorrichtung zum Erzeugen und Einkoppln eines Signals auf das Kabel, und ein Messsystem, welches ausgestaltet ist, eine Gruppenlaufzeit des Signals auf dem Kabel zu bestimmen und einen Fehlerort auf der Grundlage eines Verhältnisses zwischen der Gruppenlaufzeit und einer Laufzeit von auf dem Kabel auftretenden Teilentladungspulsen zu bestimmen.

Gemäß einer Ausführungsform ist das Kabelfehlerortungssystem zur Durchführung des zuvor beschriebenen Verfahrens zur Ortung von Fehlern auf dem Kabel ausgestaltet und umfasst daher auch die zuvor beschriebenen Vorteile.

Die vorliegende Erfindung wird nachfolgend unter Bezugnahme auf die Zeichnungen anhand bevorzugter Ausführungsformen erläutert werden.
Fig. 1 zeigt schematisch, wie mit Hilfe einer Ausführungsform eines erfindungsgemäßen Verfahrens Störungen in einem Messsignalabschnitt durch eine Mittelung mehrerer Messsignalabschnitte unterdrückt werden.
Fig. 2 zeigt ein Spektrum eines aus diskreten Frequenzen gebildeten Kalibriersignals.
Fig. 3 zeigt ein Teilentladungsmesssystem gemäß einer Ausführungsform der vorliegenden Erfindung.
Fig. 4 zeigt ein Kabelfehlerortungssystem gemäß einer Ausführungsform der vorliegenden Erfindung.

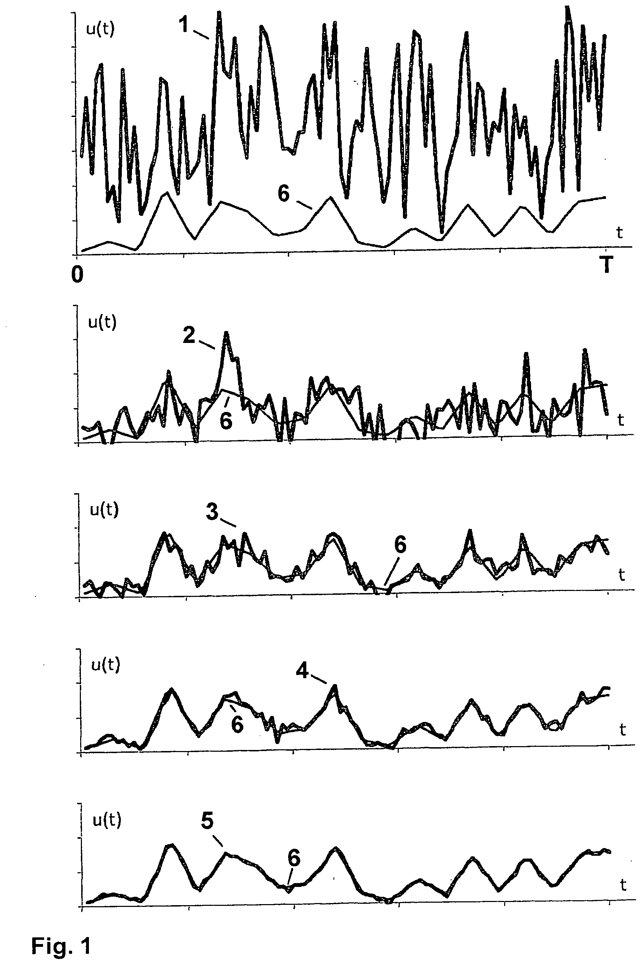

Fig. 1 zeigt einen Signalverlauf 6 mit einer vorbestimmten Periodendauer T, welcher periodisch wiederholt wird und als Kalibriersignal in ein Prüfobjekt zum Kalibrieren einer Teilentladungsmesseinrichtung eingekoppelt wird. Weiterhin ist in Fig. 1 ein Messsignalabschnitt 1 dargestellt, welcher einen entsprechenden Abschnitt eines mit der Teilentladungsmesseinrichtung erfassten Messsignals an dem Prüfobjekt zeigt, während der Signalverlauf 6 eingekoppelt wird. Der Messsignalabschnitt 1 umfasst somit ein Summensignal aus dem Signalverlauf 6 und weiteren Signalen an dem Prüfobjekt. Die weiteren Signale sind hauptsächlich überlagerte Störsignale, welche aus der Umgebung des Prüfobjekts in das Prüfobjekt eingekoppelt werden. Die Gesamtheit der weiteren Signale kann im Zusammenhang mit einer Kalibrierung der Teilentladungsmesseinrichtung als ein Störsignal aufgefasst werden. Demzufolge umfasst der Messsignalabschnitt 1 ein Summensignal aus dem Signalverlauf 6 und dem Störsignal.

Weiterhin zeigt Fig. 1 verschiedene gemittelte Messsignalabschnitte 2-5. Ein gemittelter Messsignalabschnitt 2-5 wird gebildet indem mehrere unterschiedliche Messsignalabschnitte 1 gemittelt werden. Jeder zur Mittelung verwendete Messsignalabschnitt 1 weist die vorbestimmte Periodendauer T des Signalverlaufs 6 auf und wird phasenstarr zu dem sich periodisch wiederholenden Signalverlauf 6 erfasst. Demzufolge umfasst jeder zur Mittelung verwendete Messsignalabschnitt 1 den identischen Signalverlauf 6 mit identischer Phasenlage und darüber hinaus jeweils ein individuelles Störsignal, welches aus Sicht des periodischen Kalibriersignals, d.h. bezüglich der Periodendauer und Phasenlage des Signalverlaufs 6, als zufällig angesehen werden kann. Unter der Annahme, dass die zufälligen Störsignale in den erfassten Messsignalabschnitten 1 mittelwertfrei sind, da sie beispielsweise über eine kapazitive Kopplung von dem Prüfobjekt entnommen werden, ergibt sich, dass sich die gemittelten Messsignalabschnitte 2-5 dem Signalverlauf 6 umso stärker annähern, je mehr Messsignalabschnitte 1 gemittelt werden. Der gemittelte Messsignalabschnitt 2 wurde beispielsweise durch eine Mittelung von zehn Messsignalabschnitten 1 gebildet. Der gemittelte Messsignalabschnitt 3 wurde beispielsweise durch eine Mittelung von 50 Messsignalabschnitten 1 gebildet. Der gemittelte Messsignalabschnitt 4 wurde beispielsweise durch eine Mittelung von 200 Messsignalabschnitten 1 gebildet, und der gemittelte Messsignalabschnitt 5 wurde schließlich durch eine Mittelung von 1000 Messsignalabschnitten 1 gebildet. Wie aus Fig. 1 ersichtlich ist, kann der Signalverlauf 6 trotz seiner kleinen Amplitude durch Mittelung aus Signalen mit überlagerten Störsignalen mit großer Amplitude herausgefiltert werden. Die Signalverläufe der Fig. 1 sind beispielsweise als eine Spannung über der Zeit dargestellt.

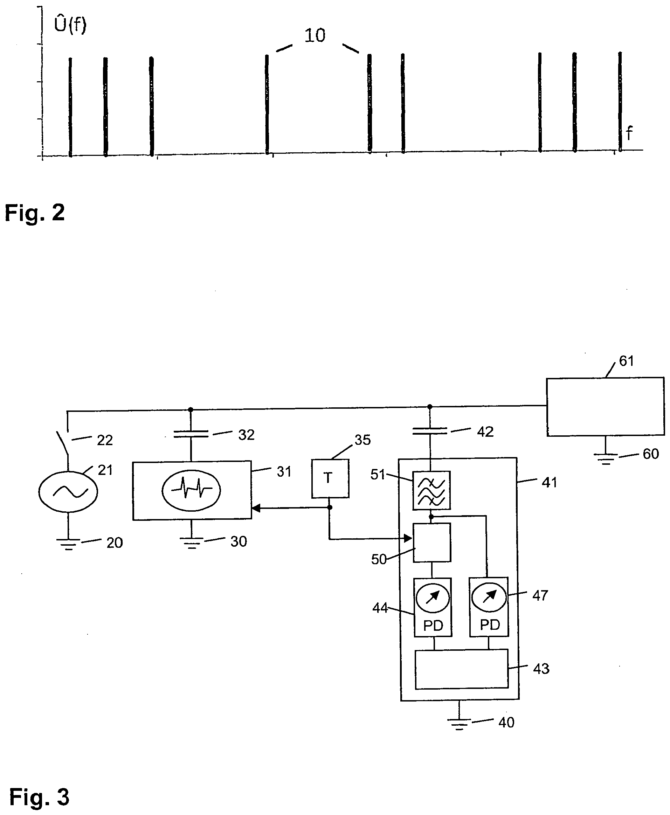

Als Signalverlauf 6 für das periodische Kalibriersignal kann beispielsweise ein pseudozufällig erzeugtes und tiefpassgefiltertes weißes Rauschen oder ein Frequenzgemisch aus diskreten Frequenzen verwendet werden. Bei Verwendung eines Frequenzgemischs aus diskreten Frequenzen sind die Frequenzen vorzugsweise so im Frequenzspektrum verteilt, dass ein gesamter möglicher Frequenzbereich einer Teilentladungsmessung abgedeckt wird, um eine Kalibrierung der Teilentladungsmesseinrichtung über dem gesamten möglichen Bereich der Teilentladungsmessung sicherzustellen. Darüber hinaus können die diskreten Frequenzen so gewählt werden, dass möglichst wenige Interferenzprobleme mit Signalen einer Teilentladungsmessung auftreten. Fig. 2 zeigt beispielhaft ein mögliches Spektrum von diskreten Frequenzen 10, welche zum Bilden des periodischen Kalibriersignals verwendet werden können.

Fig. 3 zeigt ein Teilentladungsmesssystem zum Messen von Teilentladungen in einem Prüfobjekt 61, einem so genannten Device under Test. Das Prüfobjekt 61 ist über eine Erdung 60 mit Erdpotenzial verbunden. Das Teilentladungsmesssystem umfasst eine Teilentladungsmesseinrichtung 41, einen Kalibriersignalgenerator 31 und eine Prüfspannungsquelle 21. Das Prüfobjekt 61 kann beispielsweise ein Leistungstransformator oder ein Energiekabel oder eine beliebige weitere energietechnische Einrichtung sein, bei welcher Teilentladungen auftreten können. Die Teilentladungsmesseinrichtung 41 ist über eine Koppelkapazität 42 mit dem Prüfobjekt 61 gekoppelt. Weiterhin ist die Teilentladungsmesseinrichtung 41 über eine Erdung 40 mit Erdpotenzial verbunden. Der Kalibriersignalgenerator 31 ist über eine Koppelkapazität 32 mit dem Prüfobjekt 61 gekoppelt. Darüber hinaus ist der Kalibriersignalgenerator 31 über eine Erdung 30 mit Erdpotenzial verbunden. Die Prüfspannungsquelle 21 kann über einen Schalter 22 eine Prüfspannung auf das Prüfobjekt 61 zu- und wegschalten und ist ebenfalls über eine Erdung 20 mit Erdpotenzial verbunden.

Der Kalibriersignalgenerator 31 erzeugt ein periodisches Kalibriersignal mit einem sich periodisch wiederholenden Signalverlauf, wie z.B. dem in Fig. 1 dargestellten Signalverlauf 6. Der Signalverlauf 6 weist eine vorbestimmte Periodendauer T auf, welche von einer Zeitquelle 35 des Teilentladungsmesssystems bereitgestellt wird. Über die Koppelkapazität 32 wird das periodische Kalibriersignal in das Prüfobjekt 61 eingekoppelt. Über die Koppelkapazität 42 wird ein Messsignal von dem Prüfobjekt 61 der Teilentladungsmesseinrichtung 41 zugeführt. Das Messsignal umfasst Teilentladungspulse, die möglicherweise im Prüfobjekt 61 durch die angelegte Prüfspannung entstehen, Störungen, die von außen eingekoppelt werden, sowie das Kalibriersignal, wie im Zusammenhang mit Fig. 1 beschrieben. In der Teilentladungsmesseinrichtung 41 werden durch ein Bandpassfilter 51 der Teilentladungsmesseinrichtung 41 schon möglichst viele Störungen am Eingang der Teilentladungsmesseinrichtung 41 weggefiltert. Danach wird der Messpfad aufgetrennt. In einem Messpfad wird mit Hilfe eines Mittelwertbildners 50 der Teilentladungsmesseinrichtung 41 das Messsignal über die Periodendauer T, die von der Zeitquelle 35 bereitgestellt wird, gemittelt und das Kalibriersignal kann sauber aus Störungen und Teilentladungspulsen herausgefiltert werden, selbst wenn seine Amplitude deutlich unter der von anderen Signalen liegt. Das herausgefilterte Kalibriersignal wird wie eine normale Teilentladung in einer entsprechenden Messeinheit 44 der Teilentladungsmesseinrichtung 41 gemessen. Im anderen Messpfad wird die eigentliche Teilentladung in einer entsprechenden Messeinheit 47 der Teilentladungsmesseinrichtung 41 gemessen. Durch die Wahl eines gegenüber der Teilentladung sehr kleinen Kalibriersignals beeinflusst das Kalibriersignal die eigentliche Teilentladungsmessung nur unwesentlich. Mit Hilfe einer Teilentladungsrecheneinheit 43 der Teilentladungsmesseinrichtung 41 wird die Teilentladungsmesseinrichtung 41 anhand des herausgefilterten Kalibriersignals kalibriert.

Durch die Ankopplung des Kalibriersignalgenerators 31 über einen Koppelkondensator 32 kann die Prüfspannungsquelle 21 eingeschaltet werden und gleichzeitig kalibriert werden, was einen erheblichen Vorteil gegenüber dem Stand der Technik darstellt.

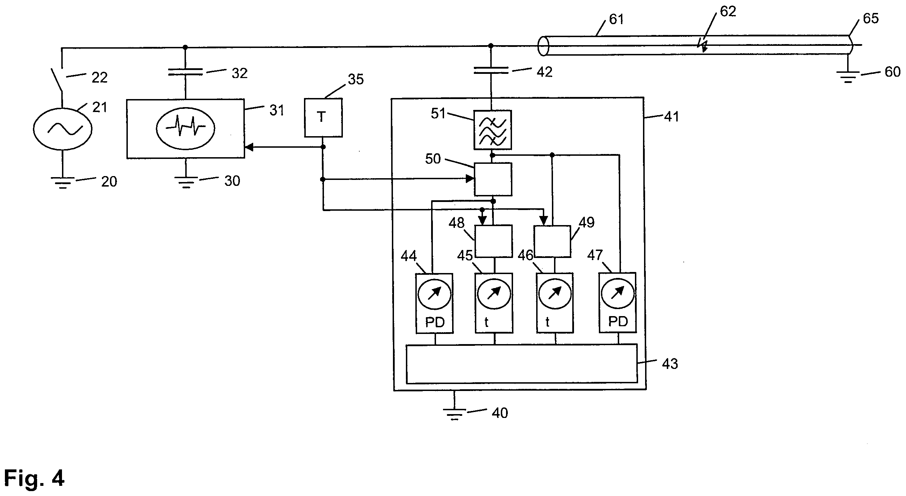

Fig. 4 zeigt für den Fall, dass das Prüfobjekt 61 ein Kabel ist, ein Kabelfehlerortungs- und Teilentladungsmesssystem, welches neben der Möglichkeit, die Teilentladungen an dem Kabel 61 wie in Fig. 3 beschrieben zu messen, zusätzlich den Ort bzw. die Orte, an dem oder an denen Teilentladungen im Kabel 61 auftreten, bestimmen kann. Komponenten, welche bereits im Zusammenhang mit Fig. 3 beschrieben wurden, weisen in Fig. 4 die gleichen Bezugszeichen auf und werden nicht wiederholt beschrieben werden.

Jeweils parallel zu den beiden Teilentladungsmesseinheiten 44 und 47 für das Kalibriersignal bzw. die echten Teilentladungen sind Laufzeitmesseinrichtungen 45 und 46 zur Zeitmessung geschaltet. Dadurch, dass hochfrequente Signale entlang einem Kabel 61 eine gewisse Laufzeit haben und zudem an einem offenen Kabelende 65 reflektiert werden, können für die Signale Autokorrelationsfunktionen bestimmt werden. Ein Autokorrelator 48 für das Kalibriersignal liefert der Zeitmesseinheit 45 ein Zeitinformation, die der doppelten Laufzeit des Signals aus der Kalibrierquelle 31 entlang dem Kabel 61 entspricht. Dadurch kann bei bekannter Laufzeit oder Ausbreitungsgeschwindigkeit für eine bestimmte Frequenz die Kabellänge, oder bei bekannter Kabellänge die Laufzeit oder die Ausbreitungsgeschwindigkeit auf dem Kabel bestimmt werden. Die eigentlichen Teilentladungsinformationen haben eine kürzere Zeitinformation, die mittels eines Autokorrelators 49 und der Zeitmesseinheit 46 ermittelt werden. Je näher eine Störstelle 62 und somit eine Teilentladungsquelle an dem Kabelende 65 ist, um so geringer ist der Abstand zwischen direktem Empfang und Echo. Mit Hilfe der Informationen aus den Zeitmesseinheiten 45 und 46 kann die Recheneinheit 43 den Fehlerort exakt bestimmen.

### BEZUGSZEICHENLISTE

- 1: Messsignalabschnitt
- 2-5: gemittelter Messsignalabschnitt
- 6: periodisch wiederholender Signalverlauf eines Kalibriersignals
- T: Periodendauer des Signalverlaufs
- 10: diskrete Frequenzen
- 20: Erdung der Prüfspannungsquelle
- 21: Prüfspannungsquelle
- 22: Schalter zur Anschaltung der Prüfspannungsquelle
- 30: Erdung des Kalibriersignalgenerators
- 31: Kalibriersignalgenerator
- 32: Koppelkapazität zur Einkopplung des Kalibriersignals
- 35: Zeitquelle mit Periodendauer T
- 40: Erdung des Messsystems
- 41: Messsystem
- 42: Koppelkapazität zur Auskopplung des Messsignals
- 43: Teilentladungs- sowie Zeitrecheneinheit
- 44: Messeinrichtung der scheinbaren Ladung des Kalibriersignals
- 45: Laufzeitmesseinrichtung des Kalibriersignals
- 46: Laufzeitmesseinrichtung für Teilentladungen
- 47: Messeinrichtung der scheinbaren Ladung für Teilentladungen
- 48: Autokorrelator für das Kalibriersignal
- 49: Autokorrelator für Teilentladungen
- 50: Mittelwertbildner bezogen auf T
- 51: Vorzugsweise variables Bandpassfilter
- 60: Erdung des Prüfobjekts
- 61: Prüfobjekt
- 62: Fehlstelle entlang des Kabels
- 65: Ende des Kabels

## Patentansprüche

1. Verfahren zur Ortung von Fehlern auf einem Kabel, umfassend:
- Einkoppeln eines Signals auf das Kabel (61),
- Bestimmen einer Gruppenlaufzeit des Signals auf dem Kabel (61),
- Bestimmen eines Fehlerorts (62) auf der Grundlage eines Verhältnisses zwischen der Gruppenlaufzeit und einer Laufzeit von auf dem Kabel (61) auftretenden Teilentladungspulsen, welche mit einem Messsignal erfasst werden, **dadurch gekennzeichnet, dass** das eingekoppelte Signal ein sich mit einer vorbestimmten Periodendauer (T) wiederholendes Signal umfasst und dass die vorbestimmte Periodendauer (T) zur Mittelung des Messsignals herangezogen wird.

2. Verfahren nach Anspruch 1, **dadurch gekennzeichnet, dass** die Laufzeitmessungen mittels einer Autokorrelation durchgeführt werden.

3. Verfahren nach Anspruch 1 oder 2, **dadurch gekennzeichnet,**
**dass** das eingekoppelte Signal ein sich mit einer vorbestimmten Periodendauer (T) wiederholendes breitbandiges Signal umfasst, und
**dass** die Gruppenlaufzeit für einen Frequenzbereich ermittelt wird, in dem eine Teilentladungsmessung durchgeführt wird.

4. Verfahren nach Anspruch 3, **dadurch gekennzeichnet, dass** das eingekoppelte Signal für eine Kalibrierung der Teilentladungsmessung verwendet wird.

5. Verfahren nach einem der Ansprüche 1-4, **dadurch gekennzeichnet, dass** das eingekoppelte Signal ein bandbegrenztes weißes Rauschen umfasst.

6. Verfahren nach einem der Ansprüche 1-5, **dadurch gekennzeichnet, dass** das Signal eingekoppelt wird, während eine Prüfspannung an dem Kabel (61) angelegt ist.

7. Verfahren nach einem der Ansprüche 1-6, **dadurch gekennzeichnet, dass** das Kabel (61) ein Energiekabel ist.

8. Verfahren nach einem der Ansprüche 1-7, **dadurch gekennzeichnet, dass** die Teilentladungspulse mit einer Teilentladungsmesseinrichtung (41) gemessen werden, wobei die Teilentladungsmesseinrichtung (41) kalibriert wird durch:
- Erzeugen eines Kalibriersignals mit Hilfe eines Kalibriersignalgenerators (31), und
- Messen eines Messsignals an dem Kabel (61),
wobei das Kalibriersignal eine vorbestimmte Periodendauer (T) aufweist und die vorbestimmte Periodendauer (T) zur Mittelung des Messsignals herangezogen wird.

9. Verfahren nach Anspruch 8, **dadurch gekennzeichnet,**
- **dass** das Kalibriersignal einen sich periodisch wiederholenden Signalverlauf (6) mit der vorbestimmten Periodendauer (T) aufweist,
- **dass** das Kalibriersignal in das Kabel (61) eingekoppelt wird,
- **dass** bei der Mittelung mehrere Messsignalabschnitte (1) des Messsignals mit jeweils der vorbestimmten Periodendauer (T) zu einem gemittelten Messsignalabschnitt (2-5) mit der vorbestimmten Periodendauer (T) gemittelt werden, und
- **dass** die Teilentladungsmesseinrichtung (41) auf der Grundlage des gemittelten Messsignalabschnitts (2-5) kalibriert wird.

10. Verfahren nach Anspruch 9, **dadurch gekennzeichnet, dass** die mehreren Messsignalabschnitte (1) jeweils die vorbestimmte Periodendauer (T) aufweisen und phasenstarr zu dem Kalibriersignal gemessen werden.

11. Verfahren nach Anspruch 9 oder 10, **dadurch gekennzeichnet, dass** das Kalibriersignal in das Kabel (61) eingekoppelt wird während eine Spannung von einer Prüfspannungsquelle (21) an dem Prüfobjekt (61) angelegt ist.

12. Verfahren nach einem der Ansprüche 9-11, **dadurch gekennzeichnet, dass** das Kalibriersignal ein bandbegrenztes weißes Rauschen umfasst.

13. Verfahren nach Anspruch 12, **dadurch gekennzeichnet, dass** das weiße Rauschen mittels einer binären Pseudozufallssequenz erzeugt wird.

14. Kabelfehlerortungssystem zur Ortung von Fehlern auf einem Kabel, umfassend:
eine Signalerzeugungsvorrichtung (31) zum Erzeugen und Einkoppeln eines Signals auf das Kabel (61), und
ein Messsystem (41), welches ausgestaltet ist, eine Gruppenlaufzeit des Signals auf dem Kabel (61) zu bestimmen und einen Fehlerort (62) auf der Grundlage eines Verhältnisses zwischen der Gruppenlaufzeit und einer Laufzeit von auf dem Kabel (61) auftretenden Teilentladungspulsen, welche mit einem Messsignal erfasst werden, zu bestimmen,
**dadurch gekennzeichnet, dass** das von der Signalerzeugungsvorrichtung (31) erzeugte und eingekoppelte Signal ein sich mit einer vorbestimmten Periodendauer (T) wiederholendes Signal umfasst, und dass das Messsystem (41) ausgestaltet ist, die vorbestimmte Periodendauer (T) zur Mittelung des Messsignals heran zu ziehen.

15. Kabelfehlerortungssystem nach Anspruch 14, **dadurch gekennzeichnet, dass** das Kabelfehlerortungssystem zur Durchführung des Verfahrens nach einem der Ansprüche 1-13 ausgestaltet ist.

## Claims

1. Method of locating faults on a cable, including:
- injecting a signal onto the cable (61),
- determining a group transit time of the signal on the cable (61),
- determining a fault location (62) on the basis of a ratio between the group transit time and a transit time of partial discharge pulses which occur on the cable (61) and which are detected with a measuring signal,
**characterized in that**
the injected signal comprises a signal which is repeated with a predetermined period duration (T), and
the predetermined period duration (T) is used for averaging the measuring signal.

2. Method according to claim 1, **characterized in that** the transit time measurements are carried out by means of auto-correlation.

3. Method according to claim 1 or claim 2, **characterized in that**
the injected signal includes a broadband signal which is repeated with a predetermined period duration (T), and
the group transit time for a frequency range in which a partial discharge measurement is carried out is determined.

4. Method according to claim 3, **characterized in that** the injected signal is used to calibrate the partial discharge measurement.

5. Method according to any one of claims 1-4, **characterized in that** the injected signal includes a band-limited white noise.

6. Method according to any one of claims 1-5, **characterized in that** the signal is injected while a test voltage is applied to the cable (61).

7. Method according to any one of claims 1-6, **characterized in that** the cable (61) is a power cable.

8. Method according to any one of claims 1-7, **characterized in that** the partial discharge pulses are measured with a partial discharge measuring device (41), the partial discharge measuring device (41) being calibrated by:
- generating a calibration signal using a calibration signal generator (31), and
- measuring a measuring signal on the cable (61),
wherein the calibration signal has a predetermined period duration (T), and the predetermined period duration (T) is used for averaging the measuring signal.

9. Method according to claim 8, **characterized in that**
- the calibration signal has a periodically repeated signal course (6) with the predetermined period duration (T),
- the calibration signal is injected into the cable (61),
- in the averaging, multiple measuring signal sections (1) of the measuring signal, each with the predetermined period duration (T), are averaged to an averaged measuring signal section (2-5) with the predetermined period duration (T), and
- the partial discharge measuring device (41) is calibrated on the basis of the averaged measuring signal section (2-5).

10. Method according to claim 9, **characterized in that** the multiple measuring signal sections (1) each have the predetermined period duration (T) and are measured phase-locked to the calibration signal.

11. Method according to claim 9 or claim 10, **characterized in that** the calibration signal is injected into the cable (61) while a voltage from a test voltage source (21) is applied to the test object (61).

12. Method according to any one of claims 9-11, **characterized in that** the calibration signal includes a band-limited white noise.

13. Method according to claim 12, **characterized in that** the white noise is generated by means of a binary pseudo-random sequence.

14. Cable fault location system for locating faults on a cable, comprising:
a signal generating device (31) for generating a signal and injecting it onto the cable (61), and
a measuring system (41) which is designed to determine a group transit time of the signal on the cable (61), and to determine a fault location (62) on the basis of a ratio between the group transit time and a transit time of partial discharge pulses which occur on the cable (61),
**characterized in that**
the signal generated and injected by the signal generating device (31) comprises a signal repeating with a predetermined period duration (T), and
that measuring system (41) is designed to use the predetermined period duration (T) for averaging the measuring signal.

15. Cable fault location system according to Claim 14, **characterized in that** the cable fault location system is designed to carry out the method according to any one of Claims 1-13.

## Revendications

1. Procédé de localisation d'erreurs sur un câble, comprenant :
- l'injection d'un signal sur le câble (61),
- la détermination d'un temps de propagation de groupe du signal sur le câble (61),
- la détermination d'un lieu d'erreur (62) sur la base d'un rapport entre le temps de propagation de groupe et un temps de propagation de pulsations de décharge partielle survenant sur le câble (61) qui sont détectées avec un signal de mesure, **caractérisé en ce que** le signal injecté comprend un signal se répétant avec une durée de période (T) prédéterminée et que la durée de période (T) prédéterminée est utilisée pour la formation de la moyenne du signal de mesure.

2. Procédé selon la revendication 1, **caractérisé en ce que** les mesures de temps de propagation sont réalisées au moyen d'une autocorrélation.

3. Procédé selon la revendication 1 ou 2, **caractérisé en ce**
**que** le signal injecté comprend un signal à large bande se répétant avec une durée de période (T) prédéterminée, et
**que** le temps de propagation de groupe est défini pour une plage de fréquence dans laquelle une mesure de décharge partielle est réalisée.

4. Procédé selon la revendication 3, **caractérisé en ce que** le signal injecté est employé pour un calibrage de la mesure de décharge partielle.

5. Procédé selon l'une quelconque des revendications 1 à 4, **caractérisé en ce que** le signal injecté comprend un bruit blanc à bande limitée.

6. Procédé selon l'une quelconque des revendications 1 à 5, **caractérisé en ce que** le signal est injecté alors qu'une tension de contrôle est appliquée sur le câble (61).

7. Procédé selon l'une quelconque des revendications 1 à 6, **caractérisé en ce que** le câble (61) est un câble d'énergie.

8. Procédé selon l'une quelconque des revendications 1 à 7, **caractérisé en ce que** les pulsations de décharge partielle sont mesurées avec un dispositif de mesure de décharge partielle (41), dans lequel le dispositif de mesure de décharge partielle (41) est calibré par :
- la génération d'un signal de calibrage à l'aide d'un générateur de signal de calibrage (31), et
- la mesure d'un signal de mesure sur le câble (61),
dans lequel le signal de calibrage présente une durée de période (T) prédéterminée et la durée de période (T) prédéterminée est utilisée pour la formation de la moyenne du signal de mesure.

9. Procédé selon la revendication 8, **caractérisé en ce**
- **que** le signal de calibrage présente une courbe de signal (6) se répétant périodiquement avec la durée de période (T) prédéterminée,
- **que** le signal de calibrage est injecté dans le câble (61),
- **que**, lors de la formation de la moyenne, la moyenne de plusieurs sections de signal de mesure (1) du signal de mesure est formée avec respectivement la durée de période (T) prédéterminée par rapport à une section de signal de mesure (2-5) dont la moyenne est formée avec la durée de période (T) prédéterminée, et
- **que** le dispositif de mesure de décharge partielle (41) est calibré sur la base de la section de signal de mesure (2-5) dont la moyenne est formée.

10. Procédé selon la revendication 9, **caractérisé en ce que** les plusieurs sections de signal de mesure (1) présentent respectivement la durée de période (T) prédéterminée et sont mesurées à phase bloquée par rapport au signal de calibrage.

11. Procédé selon la revendication 9 ou 10, **caractérisé en ce que** le signal de calibrage est injecté dans le câble (61) alors qu'une tension d'une source de tension de contrôle (21) est appliquée sur l'objet de contrôle (61).

12. Procédé selon l'une quelconque des revendications 9 à 11, **caractérisé en ce que** le signal de calibrage comprend un bruit blanc à bande limitée.

13. Procédé selon la revendication 12, **caractérisé en ce que** le bruit blanc est généré au moyen d'une séquence pseudo-aléatoire binaire.

14. Système de localisation d'erreurs de câble pour la localisation d'erreurs sur un câble, comprenant :
un dispositif de génération de signal (31) pour la génération et l'injection d'un signal sur le câble (61), et
un système de mesure (41) qui est conçu afin de déterminer un temps de propagation de groupe du signal sur le câble (61) et de déterminer un lieu d'erreur (62) sur la base d'un rapport entre le temps de propagation de groupe et un temps de propagation de pulsations de décharge partielle survenant sur le câble (61) qui sont détectées avec un signal de mesure,
**caractérisé en ce que** le signal injecté et généré par le dispositif de génération de signal (31) comprend un signal se répétant avec une durée de période (T) prédéterminée, et que le système de mesure (41) est conçu afin d'utiliser la durée de période (T) prédéterminée pour la formation de la moyenne du signal de mesure.

15. Système de localisation d'erreurs de câble selon la revendication 14, **caractérisé en ce que** le système de localisation d'erreurs de câble est conçu pour la réalisation du procédé selon l'une quelconque des revendications 1 à 13.
